# DEMANDE DE BREVET EUROPEEN

(11) **EP 2 624 670 A1**
(43) Date de publication de la demande: **07.08.2013**
(21) Numéro de dépôt: 12305120.3
(22) Date de dépôt: 31.01.2012
(51) Int. Cl.: H05K 3/10, H05K 1/18, G06K 19/077

(54) **Condensateur filaire notamment pour circuit radiofréquence et dispositif le comportant**

(71) Demandeur: Gemalto SA, 92190 Meudon (FR)
(72) Inventeur: Buyukkalender, Arek, 13013 MARSEILLE (FR); Bousquet, Christophe, 83500 LA SEYNE SUR MER (FR); Seban, Frédérick, 13260 CASSIS (FR); Lahoui, Nizar, 13400 AUBAGNE (FR)

(57) **Abrégé**

L'invention concerne un condensateur pour dispositif radiofréquence, ledit condensateur comprenant des première et seconde plaques conductrices (24, 25) en regard l'une de l'autre et séparées par un isolant (41) ;

Le condensateur se distingue en ce qu'au moins une desdites première ou seconde plaques (24) est formée par plusieurs portions de conducteur filaire (24N, 25N).

L'invention concerne également un dispositif radiofréquence comportant ce condensateur.

## Description

L'invention concerne le domaine des condensateurs. Elle vise notamment des condensateurs pour circuit transpondeur radiofréquence comprenant une première et seconde plaques conductrices en regard séparées d'un isolant et le dispositif transpondeur comportant un tel condensateur.

Les condensateurs visés par l'invention sont de préférence destinés à faire partie d'un circuit transpondeur comportant une antenne de couplage radiofréquence à laquelle ils sont reliés. De tels circuits transpondeurs appartiennent notamment au domaine de la carte à puce sans-contact ou passeport électronique. L'antenne et le condensateur forment généralement un circuit résonant. Le circuit résonant peut être passif ou actif et être relié à une puce de circuit intégré radiofréquence pour communiquer des données avec un lecteur radiofréquence.

Plus particulièrement, l'invention concerne des dispositifs tels que des supports à puce sans-contact, des cartes à puce sans contact, des étiquettes, des passeports électroniques, des dispositifs à antenne passive comportant un condensateur d'accord en fréquence. L'invention vise notamment des documents de voyage électroniques sans-contact (passeports électroniques et visas électroniques).

Ces dispositifs peuvent être conformes aux spécifications de l'ICAO (acronyme de l'expression anglo-saxonne "International Civil Aviation Organization") et/ou norme ISO/IEC 14443.

Le document US 6 378 774 illustré aux figures 1 et 2 décrit une carte à puce comprenant un module de circuit intégré (2) à interfaces de communication à contacts et à antenne. Le corps de carte comprend une antenne passive qui comprend deux bobines (3,4) reliées à un condensateur 15, une bobine large fermée pouvant être disposée sensiblement en périphérie du corps de carte et une bobine étroite disposée centrée avec l'antenne du module. La bobine large a pour fonction de communiquer vis-à-vis d'un lecteur externe et la boucle étroite a pour fonction de se coupler et de communiquer avec le module.

Cette carte à puce a l'inconvénient de présenter une construction complexe et de recourir à des technologies de réalisation de gravure en double face pour le condensateur et l'antenne, avec une étape de connexion à travers un substrat isolant de parties conductrices disposées sur des faces opposées du substrat.

On connait également un mode de réalisation de la société SPS (Smart Packaging Solutions) qui utilise un module à contact et à antenne disposé dans une cavité de corps de carte à puce bancaire. Ce module est couplé avec une antenne passive disposée sur presque toute la surface du corps de carte ; Il comprend des boucles sensiblement concentriques disposées en spirale autour de la cavité du module ; La première boucle adjacente à la cavité étant très large de plusieurs millimètres sous l'emplacement de la cavité de module voire 10 mm et les suivantes également pour permettre un embossage sur les spires sans risque de les sectionner à l'embossage. En outre, l'antenne est connectée à des plaques de condensateur métalliques disposées de part et d'autre du support d'antenne. La dernière spire s'étend en périphérie de la carte pour embrasser le plus de flux radiofréquence d'un lecteur.

Cette construction a l'inconvénient de présenter des risques de délamination dans la mesure où les feuilles plastiques constituant le corps de carte adhérent mal aux surfaces métalliques des larges spires de l'antenne et/ou des plaques de condensateur formées en gravure.

L'invention vise à résoudre les inconvénients précités.

En particulier, elle vise à simplifier la fabrication, la construction et améliorer les performances des dispositifs radiofréquences ou transpondeurs radiofréquences.

A cet effet, l'invention a pour objet un condensateur pour dispositif radiofréquence, ledit condensateur comprenant des première et seconde plaques conductrices en regard l'une de l'autre et séparées par un isolant ; Le condensateur se distingue en ce qu'au moins une desdites première et seconde plaques est formée par plusieurs portions de conducteur filaire.

Dans des modes de réalisation de l'invention, au moins une plaque (ou équivalent) peut être distincte des spires d'antenne. De préférence, la plaque est localisée en dehors du parcours des spires, par exemple à l'intérieur ou extérieur d'une bobine d'antenne.

Dans d'autres variantes, une plaque de condensateur filaire (formée de fils) forme un condensateur avec une autre plaque formée par des portions de fil de l'antenne. La plaque filaire (notamment en zigzag) est par exemple formée en regard des fils d'antenne de préférence sur un même substrat.

Grâce à ces dispositions, l'invention permet notamment de réaliser des transpondeurs (cartes sans contact, passeport électronique sans contact) avec une antenne notamment du type antenne passive, en technique filaire accédant ainsi à de meilleures performances radiofréquences, ce qui n'avait jamais été envisagé auparavant du fait de difficultés de mise en oeuvre.

Selon d'autres caractéristiques du condensateur :
- au moins plusieurs alternances de fil format une plaque filaire de condensateur, sont réalisées à cheval sur des spires de l'antenne même (ou en regard de celle-ci transversalement au plan du substrat).
- Les portions de fil sont déposées de manière guidée sur un substrat ;
- Les portions de fil forment des alternances parallèles entre elles ou des spirales ; Les alternances ou parcours continus de portions de fil sont de préférence réalisées à l'intérieur d'une zone formant une plaque de condensateur et en dehors des spires d'antenne ;
- les portions de fil des deux plaques sont déposées sur un même côté de substrat ;
- Les portions de fils de la première plaque croisent les portions de fil de la seconde plaque de manière à être sensiblement accrochées au substrat dans des zones de substrat non couvertes par les portions de fil de la première plaque ;
- Les portions de fil peuvent être déposées par broderie ou incrustation sur le substrat ;

L'invention concerne également un dispositif radiofréquence comprenant une antenne reliée à un condensateur ; Le dispositif est **caractérisé en ce que** le condensateur est formé selon l'une des caractéristiques ci-dessus.

Selon d'autres caractéristiques :
- L'antenne (A) et au moins une plaque de condensateur (C) sont formées avec des portions de fil déposées de manière guidée sur un substrat ;
- L'antenne (A) et au moins une plaque de condensateur (C) sont formées en continu à l'aide d'un même fil continu ;
- Le dispositif constitue une antenne passive accordée en fréquence avec un condensateur selon l'invention.

Grâce à l'invention :
- Les plaques de condensateur sont formées à l'aide de la même technique que celle utilisée pour réaliser l'antenne;
- L'invention permet d'avoir des antennes filaires qui sont plus performantes que des antennes obtenues par gravure chimique ou croissance électrochimique de surfaces conductrices ;
- La formation d'une antenne et d'un condensateur associé est extrêmement simplifiée puisque elle a recours à une seule technique filaire (broderie, incrustation...) ;
- L'invention assure un bon couplage radiofréquence avec une boucle moins étendue et moins de surface des spires ; Elle a l'avantage d'éviter un problème de délamination tout en libérant toute la surface d'embossage standard réservée à l'embossage.

D'autres particularités et avantages de l'invention apparaîtront à la lecture de la description faite à titre d'exemple non limitatif et en regard des dessins annexés sur lesquels :
- Les figures 1 et 2 illustrent une carte à puce à interface duale selon l'art antérieur ;
- La figure 3 illustre une vue schématique du dispositif conforme à un mode de réalisation de l'invention;
- La figure 4 illustre une vue partielle en coupe transversale du condensateur de la figure 3 ;
- La figure 5 illustre une vue schématique d'une variante de réalisation d'un dispositif conforme à l'invention ;
- La figure 6 illustre une vue schématique d'une variante de réalisation améliorée d'un dispositif conforme à l'invention.

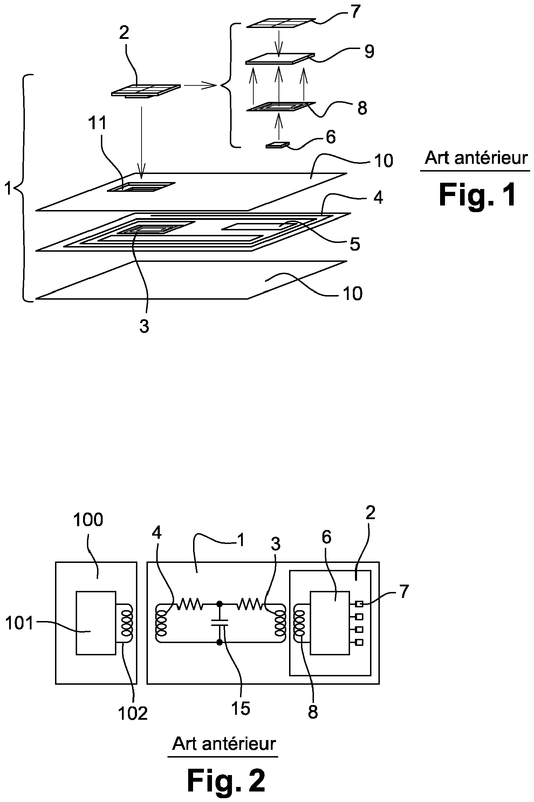

La figure 1 et 2 de l'art antérieur a été décrite précédemment en introduction. Les antennes passives sont respectivement référencées (3, 4) et (13, 14). Elles comprennent une petite boucle (3, 13) et une grande boucle (4, 14) respectivement reliée à un condensateur 15 comportant deux plaques dont celle référencée 5 (l'autre plaque étant disposée sur la face opposée du substrat d'antenne).

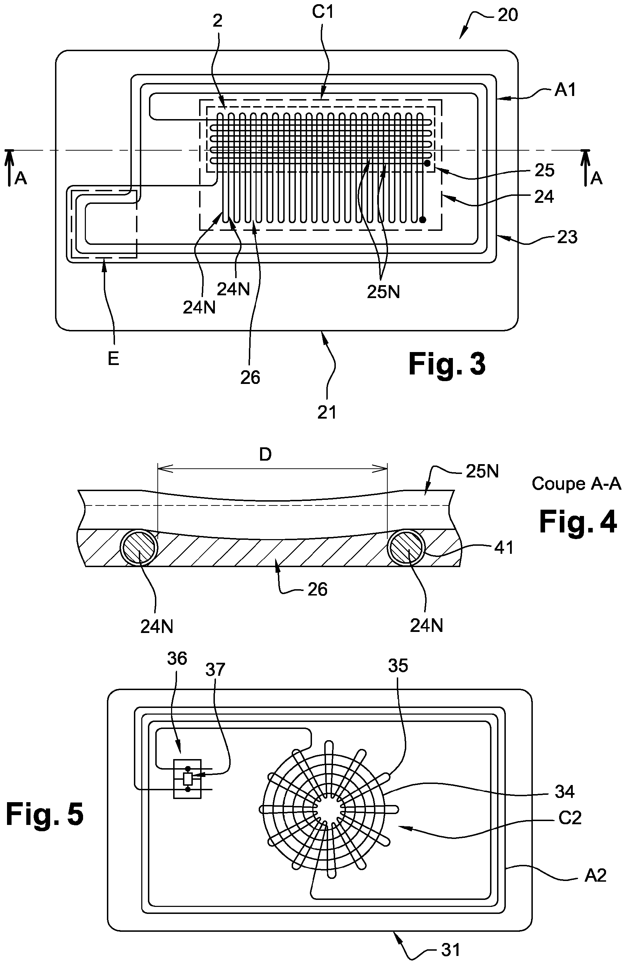

La figure 3 illustre un premier mode de réalisation d'un dispositif radiofréquence 20 conforme à l'invention ; Il comprend le condensateur C1, réalisé selon une variante de l'invention et relié ou destiné à être relié à une antenne radiofréquence A1, pour un accord en fréquence de résonance. Le condensateur et l'antenne reposent sur un substrat isolant 21 notamment en plastique, papier, etc.

Ce dispositif 20 est ici dans l'exemple une carte à puce sans-contact ou hybride à contacts et sans-contact électriques conforme au standard ISO 7816 et/ou ISO/IEC 14443. L'antenne comprend un emplacement E de transpondeur radiofréquence (non représenté). Un tel module comprend une puce de circuit intégré radiofréquence reliée à une antenne de transpondeur. Le module est de préférence sous forme de module carte à puce à interface duale, contacts (ISO 7816) et sans-contact ; Il est couplé à l'antenne passive A1 par couplage électromagnétique.

Le dispositif peut toutefois constituer un insert (inlay) pour un passeport électronique ou autre objet sans contact comme une étiquette électronique, un badge, un ticket de transport, etc. Dans ce cas, d'autres feuilles de recouvrement peuvent venir le compléter de manière connue.

Le condensateur C comprend sensiblement l'équivalent d'une première 24 et seconde 25 plaques conductrices en regard l'une de l'autre et séparées d'un isolant.

Selon une caractéristique, au moins une plaque 24 ou 25 est formée par plusieurs portions de conducteur filaire déposées de manière guidée sur un substrat. De préférence, le fil est revêtu d'un gainage et/ou isolant. L'isolant est formé au moins par le gainage ou le gainage et la matière isolante du substrat.

Les portions de fils 24N peuvent former, comme par exemple ici, des alternances parallèles ou dans d'autres cas des spirales ou autres formes quelconques (fig. 5); Les alternances sont par exemple obtenues par un balayage du fil conducteur 24N notamment en formant un zigzag sur une surface du substrat. L'espacement inter-portions de fil (fig. 4) est par exemple de 200 à 400 µm pour des fils de diamètre de 50 à 100 µm environ, soit environ 2 à 5 fois le diamètre d'un fil.

En vue de dessus, la plaque 24 ou du moins son équivalent, présente des alternances de bandes de substrat 26 et de portions de fil 24N, placées côte à côte. Ces plaques sont ajourées entre les portions de fil. Elles forment également une sorte de grille formée de fils.

La figure 4 illustre une coupe partielle transversale (A-A) du condensateur C1 ; Les portions de fil 24N formant la plaque inférieure de condensateur 24 peuvent être de préférence pratiquement enfouies 21 dans le support plastique 21 tandis que les portions de fil 25N formant la plaque supérieure 25 ne sont presque pas enfouies au niveau des croisements mais ils le sont partiellement au niveau des portions résiduelles de substrat situées entre les portions de fil 24N. Ici, la portion de substrat servant à fixer le fil 25N présente une distance D entre les portions.

Le cas échéant, au moins une plaque est formée par un parcours en forme de spirale circulaire 34 ou rectangulaire, triangulaire. Ici à la figure 4, la plaque inférieure est une spirale tandis que la plaque supérieure est réalisée en forme de zigzag comme des rayons d'un cercle contenant la plaque 34.

Le dispositif de la figure 5 comprend ou constitue un transpondeur radiofréquence tel qu'un insert pour carte à puce sans-contact. Il comprend un substrat 31 comme précédemment et un module radiofréquence comportant une puce radiofréquence 37 connectée à une antenne A2 reposant sur le substrat.

Les condensateurs sont distincts des parcours d'antenne en ce sens que les parcours sont localisés dans des endroits bien distincts des spires de l'antenne.

Les plaques de l'invention comprennent de préférence une seule liaison terminale, voire deux, pour une connexion à un composant électrique ou électronique en particulier à une antenne radiofréquence. L'invention n'exclut pas de relier ce condensateur à d'autres composants même non radiofréquence.

Les plaques peuvent avoir des surfaces différentes de manière à permettre un réglage de la capacité. La plaque supérieure présente ici sensiblement la même surface que la plaque inférieure contrairement à l'exemple de la figure 3 où la plaque inférieure est nettement plus étendue.

Les plaques peuvent être formées sur un même substrat soit sur deux substrats différents assemblés ensuite ; Les plaques peuvent être formées côte à côte sur une même face de substrat, le substrat étant ensuite replié de manière à avoir les plaques en regard l'une de l'autre.

Selon une caractéristique, les fils des deux plaques sont déposées sur un même côté de substrat par simplicité de mise en oeuvre. Dans un premier temps, on forme de manière guidée sur un substrat la première plaque (ou grille) de condensateur avec un fil selon un motif quelconque, rectangle de préférence ; Dans un second temps, on forme la deuxième plaque avec un même motif de plaque mais en déposant les portions de fil sur la première plaque de manière que les portions de fil déposées croisent les fils de la première plaque.

Il est possible également de réaliser des plaques avec des portions de fil d'une plaque qui ne croisent pas les portions de fil de l'autre plaque, par exemple en étant parallèles ou avec des portions imbriquées l'une dans l'autre et très proches notamment en forme de « U » imbriqués l'un dans l'autre.

Les fils de la première plaque croisent les fils de la seconde plaque de manière sensiblement oblique ou perpendiculaire ; Les fils de la première plaque sont accrochés au substrat dans des zones de substrat non couvertes par les fils de la première plaque.

Le cas échéant, le fil est accroché au substrat et/ou au fil de la première plaque par un adhésif apporté avec le fil ou apporté autrement de l'extérieur au fil. Un apport d'énergie thermique par soufflage ou par ultrasons permet de fixer le fil de plaque de condensateur sur le substrat et/ou le fil.

Dans l'exemple, les fils sont déposés par incrustation à ultrasons sur le substrat ; toutefois, d'autres techniques filaires comme la broderie ou la couture peuvent convenir.

Les portions de fil des deux plaques de la figure 5 sont déposées sur un même côté de substrat 31.

Selon d'autres variantes de mise en oeuvre, l'invention prévoit de réaliser des capacités en série en multipliant les plaques superposées. Ces plaques ou grilles peuvent être formées avec un parcours continu d'un fil.

Par ailleurs, l'invention prévoit de réaliser des plaques ou grilles superposées sur le parcours de spires d'antenne.

Ainsi, un assemblage en série de condensateurs est obtenu soit en superposant au moins trois plaques, soit en réalisant au moins deux condensateurs superposés sur un parcours d'une même spire (ou d'une même piste conductrice si pas d'antenne).

Par exemple au cours de la réalisation d'une spire, l'outil de guidage de fil sur le substrat réalise une plaque en zigzag ou en forme de grille quelconque, puis le fil d'un second tour ou tour subséquent de spire réalise la seconde plaque et/ou autres plaques subséquentes pour avoir des condensateurs en série les uns avec les autres.

L'avantage de condensateur en série est de gagner de la surface consacrée aux plaques.

Alternativement, après avoir réalisé une première plaque, l'invention prévoit de réaliser la seconde plaque ou nième plaque dans la foulée de la première avec un fil continu, par exemple en faisant repasser le fil sur la grille qui vient d'être formée avant de poursuivre le parcours d'antenne.

Dans le cas d'une incrustation par ultrasons, il n'est pas nécessaire de lever l'outil à ultrasons ou de stopper les ultrasons à chaque croisement des fils.

De manière avantageuse, sur les figures 3 ou 4, l'antenne et au moins une plaque de condensateur sont formées avec du fil déposé de manière guidée sur un substrat. Ici, les deux plaques et l'antenne sont réalisées par un parcours continu d'un fil conducteur sur une même face du substrat sans changer d'outil.

Le dispositif comprend dans l'exemple une antenne passive 23 accordée ou destinée à être accordée en fréquence avec au moins un transpondeur radiofréquence 22;

D'une manière générale, dans le cadre de la présente description, on entend par transpondeur tout circuit électronique radiofréquence communicant à l'aide d'un champ électromagnétique et comportant une bobine connectée à un condensateur et/ou à un circuit intégré.

Les transpondeurs sont utilisés dans différents domaines économiques tels que le bancaire (porte-monnaie électronique), la communication, le transport, l'identité (e-passeport, ID-carte). Dans l'identité notamment, il est connu d'effectuer l'identification d'une personne par communication radiofréquence avec un objet électronique portable sans contact de type RFID.

Le module peut comprendre ou non un substrat isolant supportant des plages de contact et/ou de l'antenne.

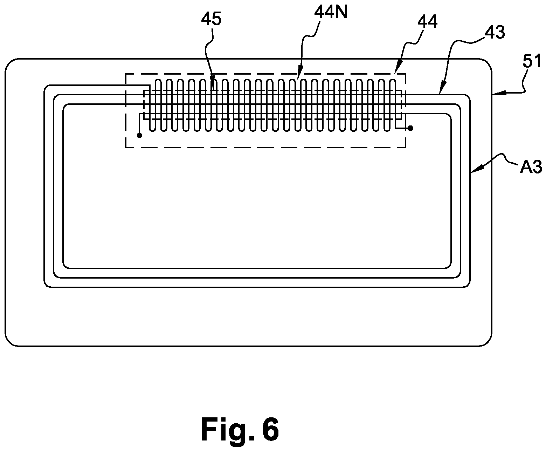

La figure 6 illustre une variante de mise en oeuvre optimisée de l'invention. Elle vise à réaliser une capacité filaire 44, 45 notamment par incrustation de fil ou broderie sans ajouter de matériau supplémentaire que celui utilisé pour l'antenne.

Une plaque de condensateur 44 est réalisée par des alternances 44N sur les spires de l'antenne A3 même. L'ensemble des portions des spires situées en regard des alternances forme l'autre plaque 45 de condensateur.

Au cours de la réalisation ou au début ou en fin de réalisation d'une spire d'antenne sur un substrat 51, (par exemple au format carte à puce standard), l'outil de guidage et de fixation du fil d'antenne fait croiser les spires d'antenne A3 en faisant de multiples alternances ou zigzags 44N sur les spires ; Les alternances sont par exemple orientées de l'extérieur vers l'intérieur de l'antenne A3.

Un condensateur est ainsi formé avec une première plaque 44N formée par plusieurs alternances continues (au moins deux ou au moins cinq) du fil croisant une portion des spires d'antenne.

La portion des spires en regard de l'armature 44N forme l'autre plaque de condensateur. Ainsi, au moins une desdites première et seconde plaques est formée à cheval sur l'antenne A3 en croisant des spires d'antenne.

La capacité est ici du type parallèle mais d'autres montages permettent d'avoir un condensateur en série.

Les coûts sont largement réduits comparativement à d'autres technologies qui permettent de réaliser cette antenne (gravure, antennes d'aluminium, technique additive ou soustractive de matériaux, circuits imprimés.

La technologie filaire notamment en fil incrusté n'a jamais été utilisée pour fabriquer une antenne relais (ou de type passive pour amplification) notamment parce qu'il est très difficile de le faire ainsi.

L'invention permet d'avoir une antenne filaire notamment en fil incrusté sur un substrat, avec tout diamètre de fil ou facteur de forme, avec toute forme de boucle, tout espacement inter-spires et toute dimension.

L'invention de cette variante consiste à créer une ou plusieurs capacités avec des spires de l'antenne.

Les fils de cuivre isolés, permettent de créer des capacités notamment parallèles sur les portions terminales des antennes sans avoir de court-circuit entre les première et deuxième plaques de condensateur ainsi formées.

Le principe de cette variante améliorée peut être étendu à une antenne normale (non passive) pour ajouter de la capacité à un transpondeur existant afin d'améliorer ses performances radiofréquences (par exemple, l'ajout d'une capacité filaire à un transpondeur utilisant une puce radiofréquence incorporant déjà une capacité de faible valeur, améliorera ses performances radiofréquences notamment pour des antennes de petites dimensions).

Elle permet d'avoir des antennes dont l'encombrement en surface est réduit de moitié par rapport à des antennes traditionnelles dans les cartes au format ISO bancaires. Cette variante a l'avantage d'améliorer la cadence des machines de réalisation d'antenne et le rendement du fait d'une seule zone en zigzag. En outre, il n'y a pas ou moins d'image fantôme (marque visible à l'oeil nu par relief ou transparence) sur la carte finale du fait que la capacité est réalisée dans la zone des spires de l'antenne même.

## Revendications

1. Condensateur pour dispositif radiofréquence, ledit condensateur comprenant des première (24, 44) et seconde plaques conductrices (25, 45) en regard l'une de l'autre et séparées par un isolant (41), **caractérisé en ce qu'**au moins une desdites première et seconde plaques (24, 44) est formée par plusieurs portions de conducteur filaire (24N, 25N, 44N).

2. Condensateur selon la revendication précédente, **caractérisé en ce que** les portions (24N, 25N) sont déposées de manière guidée sur un substrat.

3. Condensateur selon l'une quelconque des revendications précédentes, **caractérisé en ce que** lesdites portions de fil forment des alternances parallèles entre elles ou des spirales

4. Condensateur selon l'une quelconque des revendications précédentes, **caractérisé en ce que** les portions de fil des deux plaques sont déposées sur un même côté de substrat (21).

5. Condensateur selon l'une quelconque des revendications précédentes, **caractérisé en ce que** les portions de fil (24N) de la première plaque (24) croisent les portions de fil de la seconde plaque (24) de manière sensiblement à être accrochées au substrat dans des zones de substrat (26) non couvertes par les portions de fil (24N) de la première plaque.

6. Condensateur selon l'une quelconque des revendications précédentes, **caractérisé en ce que** les portions de fil (24N, 25N) sont déposées par broderie ou incrustation sur le substrat.

7. Condensateur selon l'une quelconque des revendications précédentes, **caractérisé en ce qu'**il comprend un assemblage série de condensateurs obtenus soit en superposant au moins trois grilles ou plaques, soit en réalisant au moins deux condensateurs superposés sur un parcours d'une même spire ou d'une piste.

8. Condensateur selon l'une quelconque des revendications précédentes, **caractérisé en ce qu'**au moins une (44) desdites première et seconde plaque est formée à cheval sur l'antenne (A3)en croisant des spires d'antenne.

9. Dispositif radiofréquence comprenant une antenne reliée à un condensateur, **caractérisé en ce que** le condensateur est formé selon l'une quelconque des revendications précédentes.

10. Dispositif selon la revendication précédente, **caractérisé en ce que** l'antenne (A) et au moins une plaque de condensateur (C) sont formés avec des portions de fil déposées de manière guidée sur un substrat.

11. Dispositif selon l'une des revendications 9 à 10, **caractérisé en ce que** l'antenne (A) et au moins une plaque de condensateur (C) sont formées en continu à l'aide d'un même fil continu.

12. Dispositif radiofréquence selon l'une quelconque des revendications 9 à 11, **caractérisé en ce qu'**il constitue une antenne passive accordée en fréquence.

13. Dispositif radiofréquence selon l'une quelconque des revendications 9 à 12, **caractérisé en ce qu'**il comprend un assemblage de condensateurs en série obtenu soit en superposant au moins trois plaques, soit en réalisant au moins deux condensateurs superposés sur un parcours d'une même spire ou d'une piste.
